# EUROPEAN PATENT SPECIFICATION

(11) **EP 0 540 321 B1**
(45) Date of publication and mention of the grant of the patent: **23.09.1998**
(21) Application number: 92309892.5
(22) Date of filing: 28.10.1992
(51) Int. Cl.: H01L 21/3105, H01L 21/768

(54) **A method for fabricating an interlayer-dielectric film of BPSG in a semiconductor device**
Verfahren zur Herstellung einer dielektrischen BPSG-Zwischenschicht einer Halbleitervorrichtung
Procédé de fabrication d'une couche intermédiaire diélectrique de BPSG d'un dispositif semi-conducteur

(30) Priority: 30.10.1991 KR 9119176
(43) Date of publication of application: 05.05.1993
(73) Proprietor: SAMSUNG ELECTRONICS CO. LTD., Suwon, Kyungki-do (KR)
(72) Inventor: Kim, Changgyu, Suwon, Kyungki-do (KR); Hong, Changki, Kwonsun-ku, Suwon, Kyungki-do (KR); Chung, Uin, Changan-ku, Suwon, Kyungki-do (KR); Ahn, Yongchul, Ahnyang, Kyungki-do (KR)
(74) Representative: Kensett, John Hinton

(56) References cited:
- US-A- 4 799 992
- DATABASE WPIL Section Ch, Week 4292, Derwent Publications Ltd., London, GB; Class L, AN 92-343076 & JP-A-4 245 630 (KAWASAKI STEEL CORP.) 2 September 1992
- PATENT ABSTRACTS OF JAPAN vol. 012, no. 320 (E-651)30 August 1988 & JP-A-63 086 426 ( T0SHIBA CORP. ) 16 April 1988
- PATENT ABSTRACTS OF JAPAN vol. 014, no. 455 (E-0985)28 September 1990 & JP-A-2 181 952 ( SONY CORP. ) 16 July 1990

## Description

The present invention relates to a method for fabricating an interlayer dielectric film of a semiconductor device. Particularly, it relates to a method for fabricating an interlayer dielectric film of a semiconductor device capable of surmounting the limit of borophosphosilicate concentrations and removing encroachment in the case of H₂SO₄ boiling by performing a surface treatment after deposition of borophosphosilicate glass films.

Some very large scale integration processes (VLSI) would benefit from being performed at lower temperatures than those necessary for phosphosilicate glass(PSG) reflow (1,000-1,100°C). because such high temperatures results in excessive diffusion of junctions. Furthermore, metal oxide semiconductor gate oxides cannot be exposed to high temperature processing (beyond 900°C). However, flowable glass is still very desirable for easing film coverage over abrupt steps in the substrate topography. Glass flow temperatures as low as 700°C can be obtained by adding boron dopant (e.g. B₂H₆) to the PSG gas flow to form the ternary (three component) oxide system B₂O₃-P₂O₅-SiO₂, borophosphosilicate glass, or BPSG.

BPSG flow depends on film composition, flow temperature, flow time, and flow ambient. Reportedly, an increase in boron concentration of 1 wt% in BPSG decreases the required flow temperature by about 40°C. In general, increasing the P concentration beyond about 5wt% does not further decrease BPSG flow temperatures. An upper limit on boron concentration is imposed by film stability. That is, BPSG films containing over 5 wt% boron tend to be very hygroscopic and unstable, and if used, should be flowed immediately following deposition. It has also been reported that rapid thermal annealing for 30 seconds at a temperature 100-175°C higher than that used in a conventional furnace step will result in equivalent BPSG flow. The ambient gas of the flow cycle also affects the flow mechanism. By using a steam ambient instead of N2, the minimum required flow temperature is reduced by about 70°C.

In addition to exhibiting these low temperature flow properties, BPSG (like PSG) is an alkali ion getter and exhibits low stress. Because of its doping, however, BPSG can also be an unwanted diffusion source to underlying silicon. It is found that BPSG is primarily a source of phosphorus, and the phosphorus outdiffusion is increased at higher boron concentrations.

Because of the BPSG characteristics as mentioned above, atmospheric pressure chemical vapor deposition (APCVD) using O₃ and organic-source is recently used. This example is disclosed in page 6 of the Ozone/Organic-Source APCVD for ULSI Reflow Glass Films, by Yasuo IKEDA, Youichirou NUMASAWA and Mitsuru SAKAMOTO-VLSI Development DIVISION, NEC Res. & Develop. No. 94, published on July, 1987.

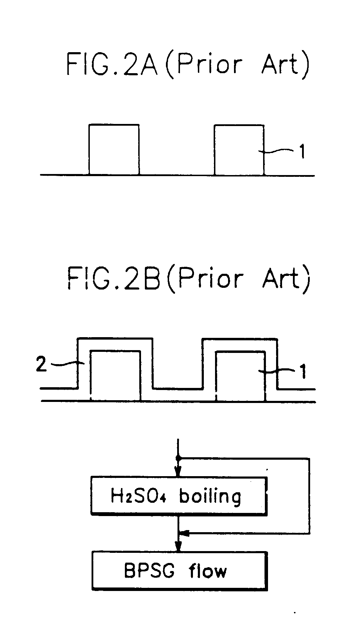

In accordance as devices of BPSG used as an interlayer dielectric film become submicron, BPSG reflow causes junction breakdown by thermal stress, and so BPSG low temperature reflow processing is needed. According to the conventional process technology, planarization of interlayer dielectrics (ILD) is accomplished by carrying out H₂SO₄ boiling and BPSG reflow as the following deposition. FIGS. 2A and 2B show processing flow diagrams according to a conventional art technology. FIG. 2A depicts a pattern where a conductor 1 is formed and FIG. 2B depicts that BPSG 2 is deposited on the conductor 1. After BPSG of high concentrations (each concentration from 4 to 15 wt% of both B and P) is deposited, H₂SO₄ boiling is carried out together with a surface treatment, and BPSG is then flowed. As the manufacture of from 1M bit DRAMs to 64M bit DRAMs has been achieved, BPSG low temperature reflow under 850°C is required.

Outer-shell electron of B or P in BPSG is different from that of silicon ion, and as the number of coordination for B and P is respectively changed from 3 to 4 and from 5 to 4, deficiency or increase in oxygen ion occurs. And the network structure between atoms becomes weak, and the melting point drops. The more the concentration of both B and P in the film increase, the more the melting point drops because the network structure becomes weak. However, in the case where BPSG films containing B and P of high concentrations are deposited and H₂SO₄ boiling is carried out, the films are damaged to exhibit more of a tendency to crack. If BPSG films are left in the air, they react with atmospheric humidity to crack, and therefore, an expected object for using BPSG films cannot be attained.

An object of the present invention is to solve the above-mentioned conventional disadvantage, and to provide a method for fabricating an interlayer BPSG dielectric film of a semiconductor device capable of preventing exterior stress resulted from H₂SO₄ boiling or absorption of atmospheric humidity.

Another object of the present invention is to provide a method for fabricating an interlayer BPSG dielectric film of a semiconductor device having good flow properties at low temperatures without crack or bursting of the borophosphosilicate glass (BPSG), by preventing BPSG from becoming stressed due to high concentrations of B and P.

In order to achieve the above objects, the present invention provides a method for fabricating an interlayer dielectric film comprising the steps of: preparing a semiconductor substrate having electrical elements thereon; depositing a borophosphosilicate dielectric glass film on said substrate; carrying out a surface treatment on said dielectric film through plasma processing using a plasma source gas containing oxygen radicals; and performing reflow at temperatures below 850°C.

The plasma source gas for the surface treatment may be selected from among N₂O, O₂ or O₃.

The boron concentration may preferably be from 4 to 15 wt%.

The phosphorous concentration may preferably be from 4 to 15 wt%.

The method may further include the step of wet cleaning the surface of the dielectric film by H₂SO₄ boiling prior to the low temperature reflow processing.

Embodiments of the present invention will now be described, by way of example only, with reference to the accompanying drawings, in which:
FIGS. 1A to 1C show processing flow diagrams according to the present invention;
FIGS. 2A and 2B show processing flow diagrams according to a conventional art technology;
FIGS. 3A to 3C and 4A to 4C show sectional views from scanning electron microscope (SEM) after the surface treatment according to the present invention; and
FIGS. 5A to 5C show sectional views from an SEM after the surface treatment according to the conventional art technology.

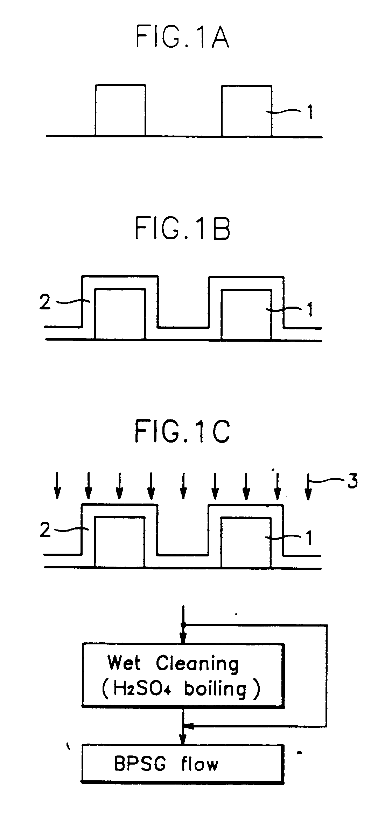

FIGS. 1A to 1C depict processing flow diagrams according to the present invention. FIG. 1A shows the formation of a conductor 1 and FIG. 1B shows a borophosphosilicate glass (BPSG) 2 deposited on the conductor 1. After deposition of BPSG (the concentration of both B and P preferably being from 4 to 15 wt%), a dry-etching 3 is performed, as shown in 1C. Plasma etching is used in such an etching.

In order to attain the object of the present invention as mentioned above, O₃-Tetraethylorthosilicate (TEOS) BPSG is used, and the deposition condition may be as follows: TEOS-3SLM; Trimethylborate (TMB)-40mg; Trimethylphosphate (TMOP)-1.5SLM; O₃ concentration-5%; O₃+O₂ flow-7.5SLM; and temperature-420°C.

Three O3-TEOS BPSGs are deposited to a thickness of 6000 angstroms (10Å=1nm) on polysilicon with the condition as mentioned above. Among them, one is treated by an N₂O plasma processing, another is treated by an N₂+NH₃ plasma processing, and the other is treated by the conventional treatment without etching (FIGS. 2A to 2C). After that, these three patterns will undergo H2SO4 boiling under the same condition as each other and then flowed in a nitrogen ambient for 30 minutes at 850°C.

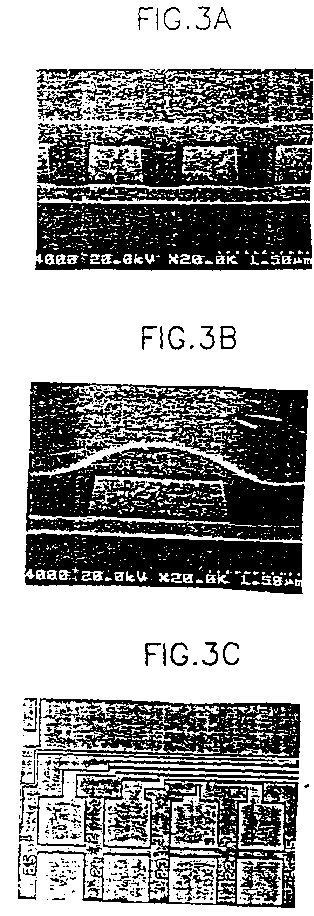

As a result of this experiment, the pattern treated by the N₂O plasma processing after the deposition of BPSG of high concentration shows no encroachment by H₂SO₄ boiling and has good flow characteristic (refer to FIGS. 3A to 3C).

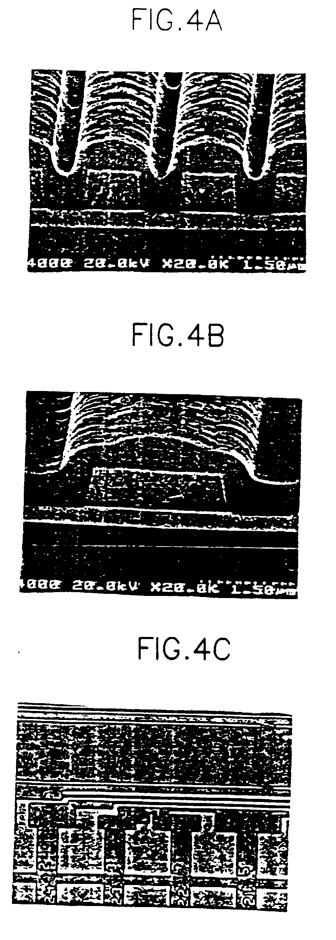

In the meantime, the pattern treated by the N₂+NH₃ plasma processing shows a little encroachment and its flow characteristic is not very good (FIGS. 4A to 4C).

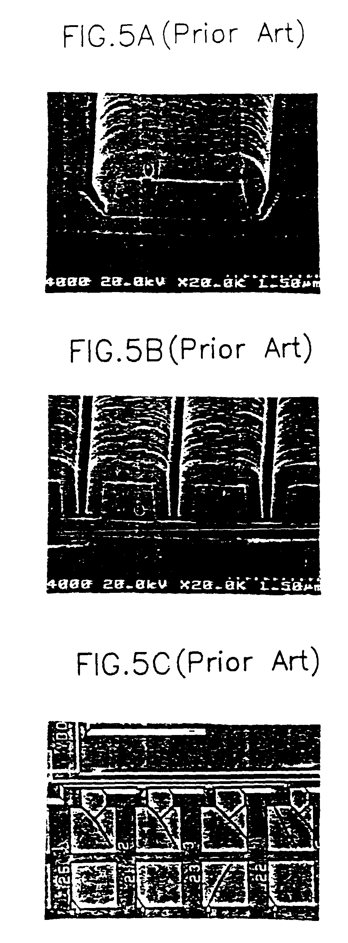

However, the BPSG pattern of high concentration treated in the conventional way shows severe cracks by H₂SO₄ boiling (FIG. 5).

FIGS. 3A, 4A and 5A are SEM micrographs showing side-sectional views of FIGS. 3C, 4C and 5C, and FIGS. 3B, 4B and 5B are partial enlarged views of FIGS. 3A, 4A and 5A.

The plasma processing condition of the present experiment may be as follows: temperature ranging from 200°C, RF power of 150W, and the plasma source gas, N₂O and N₂+NH₃ separately for five minutes. Even if this condition changes and the plasma source gas is substituted with O₃ or O₂, etc., similar characteristics to the aboves can be obtained. That is, unstable free B₂O₃ on the surface of the BPSG is processed by N₂O or O₂ plasma etching thereby changing into B-O-Si structure, or forming a new SiOx film.

On condition that BPSG is flowed for 30 minutes at a temperature 800°C in N₂ ambient, in the case where etching on the surface and H2SO4 boiling are carried out after the deposition of BPSG of high concentrations, B and P spectrums are similar to spectrum of the deposition state but in the case where the surface treatment is not carried out, pick of B is remarkably decreased.

When it comes to shrinkage, the former case is outstandingly smaller than the latter case. Carrying out the surface treatment after the deposition of BPSG can prevent encroachment caused by humidity absorption from the exterior and outdiffusion of boron such that excellent flow characteristics is achieved with reflow temperatures of less than 850°C. In addition thereto, problems such as junction breakdown by thermal stress can be removed.

BPSG of high concentrations may be used according to the present invention. In the prior art encroachment caused by H₂SO₄ boiling or by humidity absorption from the exterior is severely shown, especially in accordance with the increase in B concentrations, and there has been the limit of B and P concentrations. According to the present invention, however, BPSG of high concentrations may be used, and by dropping the melting point of BPSG, low temperature flow can be performed.

## Claims

1. A method for fabricating an interlayer dielectric film comprising the steps of:
preparing a semiconductor substrate having electrical elements thereon;
depositing a borophosphosilicate dielectric glass film on said substrate;
carrying out a surface treatment on said dielectric film through plasma processing using a plasma source gas containing oxygen radicals; and
performing reflow at temperatures below 850°C.

2. A method according to Claim 1, wherein the plasma source gas is selected from N₂O, O₂ and O₃.

3. A method according to Claim 1 or Claim 2, wherein said boron concentration is from 4 to 15 wt%.

4. A method according to any of the preceding claims, wherein said phosphorous concentration is from 4 to 15 wt%.

5. A method according to any of the preceding claims, further including the step of wet cleaning the surface of the dielectric film by H₂SO₄ boiling prior to said low temperature reflow processing.

## Patentansprüche

1. Verfahren zur Herstellung einer dielektrischen Zwischenschicht, umfassend die Schritte:
Herstellen eines Halbleitersubstrats mit darauf befindlichen elektrischen Elementen;
Abscheiden einer dielektrischen Borphosphosilicat-Glasschicht auf dem Substrat;
Ausführen einer Oberflächenbehandlung auf der dielektrischen Schicht durch Plasmabearbeitung unter Verwendung eines Plasmaquellengases, das Sauerstoffradikale enthält; und
Durchführen einer Aufschmelzung bei Temperaturen unter 850°C.

2. Verfahren nach Anspruch 1, wobei das Plasmaquellengas aus N₂O, O₂ und O₃ ausgewählt ist.

3. Verfahren nach Anspruch 1 oder Anspruch 2, wobei die Borkonzentration 4 bis 15 Gew.% beträgt.

4. Verfahren nach einem der vorangehenden Ansprüche, wobei die Phosphorkonzentration bis 15 Gew.% beträgt.

5. Verfahren nach einem der vorangehenden Ansprüche, ferner umfassend den Schritt des Naßreinigens der Oberfläche der dielektrischen Schicht durch H₂SO₄-Kochen vor der Aufschmelzbearbeitung bei niederer Temperatur.

## Revendications

1. Procédé de fabrication d'un film diélectrique formant couche intermédiaire comprenant les étapes consistant à :
préparer un substrat semi-conducteur sur lequel sont prévus des éléments électriques ;
déposer un film de verre diélectrique en borophosphosilicate sur ledit substrat ;
procéder à un traitement de surface sur le film diélectrique par traitement par plasma en utilisant un gaz source de plasma contenant des radicaux oxygène ; et
procéder à une fusion à des températures inférieures à 850°C.

2. Procédé selon la revendication 1, dans lequel le gaz source de plasma est sélectionné parmi N₂O, O₂ et O₃.

3. Procédé selon l'une des revendications 1 et 2, dans lequel ladite concentration de Bore se situe entre 4 et 15% en poids.

4. Procédé selon l'une quelconque des revendications précédentes, dans lequel ladite concentration en phosphore est comprise entre 4 et 15% en poids.

5. Procédé selon l'une quelconque des revendications précédentes, comportant une étape de nettoyage à sec de la surface du film diélectrique par ébullition de H₂SO₄ préalablement audit traitement par fusion à basse température.
